# EUROPEAN PATENT SPECIFICATION

(11) **EP 1 657 859 B1**
(45) Date of publication and mention of the grant of the patent: **15.05.2013**
(21) Application number: 04772098.2
(22) Date of filing: 18.08.2004
(51) Int. Cl.: H04L 12/747, G11C 15/04

(54) **PROTOCOL SPEED INCREASING DEVICE**
EINRICHTUNG ZUR VERGRÖSSERUNG DER PROTOKOLLGESCHWINDIGKEIT
DISPOSITIF AUGMENTANT LA VITESSE DU PROTOCOLE

(30) Priority: 20.08.2003 JP 2003296408; 22.08.2003 JP 2003298734
(43) Date of publication of application: 17.05.2006
(73) Proprietor: NIPPON TELEGRAPH AND TELEPHONE CORPORATION, Tokyo 100-8116 (JP)
(72) Inventor: UGA, Masanori, c/o NTT Intellectual Property Center, Musashino-shi, Tokyo 180-8585 (JP); KURIMOTO, Takashi., c/o NTT Intellectual Property Center, Musashino-shi, Tokyo 180-8585 (JP); AOKI, Michihiro, c/o NTT Intellectual Property Center, Musashino-shi, Tokyo 180-8585 (JP)
(74) Representative: Ahner, Philippe
(86) International application number: PCT/JP2004/012137
(87) International publication number: WO 2005/020525

(56) References cited:
- WO-A2-02/061625
- WO-A2-02/102000
- JP-A- 2000 030 469
- JP-A- 2002 204 250
- JP-A- 2002 208 943
- JP-A- 2002 208 945
- JP-A- 2002 208 945
- JP-A- 2003 023 437
- JP-A- 2003 101 573
- SHAH D ET AL: "Fast incremental updates on ternary-CAMs for routing lookups and packet classification" PROCEEDINGS OF HOT INTERCONNECTS, XX, XX, 1 January 2000 (2000-01-01), pages 1-7, XP002958517

## Description

### TECHNICAL FIELD

The present invention relates to a technique for generating routing tables that are used to calculate the shortest path to a destination to which a packet is to be sent using a shortest path algorithm, such as Dijkstra, based on information exchanged or collected using a routing protocol, such as the Open Shortest Path First (OSPF) or the Intermediate System to Intermediate System (ISIS), or the like.

In addition, the present invention is used for an interface of a packet transfer device, such as an IP router, that executes necessary processing (for example, determining the shortest path to a destination from a destination address, and determining to which channel the packet is to be sent) to packet that is input via an input channel. In particular, the present invention is related to a technique to process received information using a control packet that is received using a routing protocol, such as the Open Shortest Path First (OSPF), or the Intermediate System to Intermediate System (ISIS), or the like.

### BACKGROUND ART

A conventional routing table generating unit typically includes an external memory (an SRAM or SDRAM) and an information processing unit. In such a routing table generating unit, the information processing unit classifies items in received information, generates a search tree from items that uniquely identify the information, and stores the received information and the structural information of the tree into the tree.

A routing protocol, such as the OSPF, the ISIS, or the like, is used to exchange control messages between packet transfer devices, such as routers, and to determine shortest paths from link cost information of the packet transfer devices on a network. Control messages are broadcasted to all packet transfer devices within the network upon every update on the network status and/or periodically.

A router determines whether or not a control message is new upon receiving the control message, by searching a link state database (hereinafter referred to as "LSDB") that is generated based on control messages. However, in the conventional technique, only a routing device (hereinafter referred to as "route server (RS)") that controls the routing protocol executes all of such searches on the LSDB.

The speed of an LSDB search is dependent on the memory access speed. In many packet transfer devices, a personal computer card is used as an RS which is equipped with a low-speed memory for the reason of cost reduction. Furthermore, even when a personal computer card is not used, an inexpensive low-speed memory is still used since a large amount of memory is required to run various application programs or an operating system on the RS. Thus, fast search of the LSDB is impossible.

In addition, in a conventional technique, in order to execute an LSDB search on an RS, a search tree is generated for searches. The RS classifies items in information in a control packet that has been transferred from an interface, generates a search tree from items that uniquely identify the information, and stores the received information and the structural information of the tree into the tree.

In the following, a Patricia tree, that is one of most commonly used search trees, will be explained. A Patricia tree is one type of binary search tree, in which nodes are connected by pointers to define a tree.

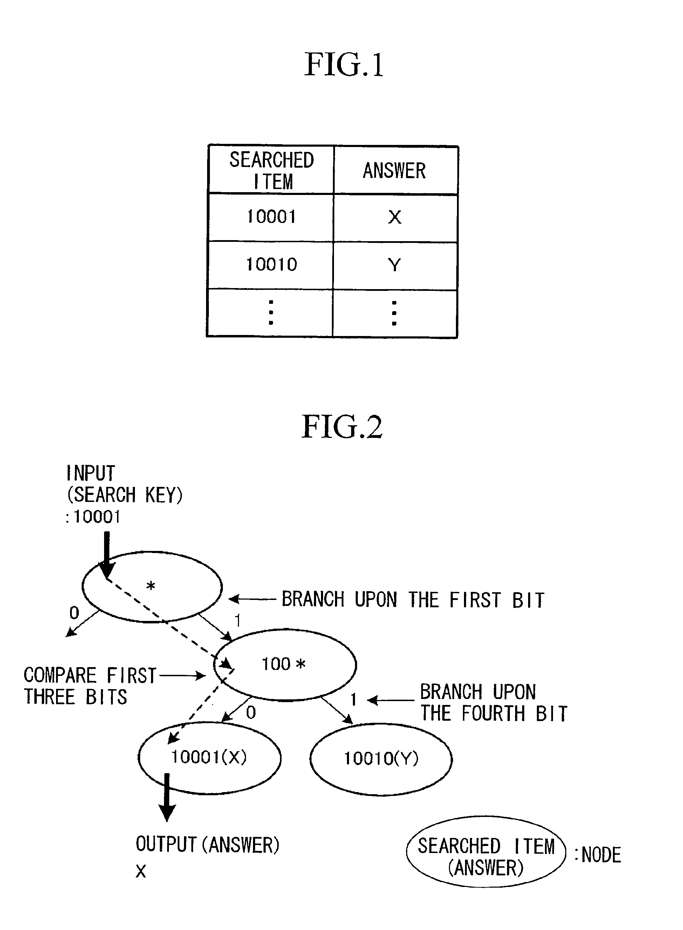

A search table that lists searched items and answers of the items is shown in FIG. 1. FIG. 2 illustrates an example of a search on the search table shown in FIG. 1 using a Patricia tree. For the simplicity of illustration, each field is represented using binary numbers and the field length is five bits. The symbol "*" indicates that the bit values following this symbol is to be ignored upon search.

Upon search, a search key to be found and the items to be matched contained in nodes are compared while moving the tree downward. Upon reaching a node, the searched bits of an item contained in the node and the searched bits of the search key are compared. (The searched bits is the bits from the first bit of the key to the bit before the "*". If a field has a value of "100*," the first three bits are compared). If the two do not match, the search ends with a result of no match. If there is a match, the bit next to the last bit of the searched bits in the search key is examined. When the current node has any lower node (hereinafter referred to as a "child node"), the search is continued on the child nodes. The search ends when all of the bits match in a node, and the answer is the item contained in that node.

In the example shown in FIG. 2, the search key "10001" is searched. First, a determination of whether the first one bit of the search key is "0" or "1" is made. In this example, the first one bit is "1," then the search is continued on the node "100*" and the first three bits are compared. Since they match, the next bit, the fourth bit in the search key, is examined. The examined bit is "0", and the search is moved to the node "10001." The search ends in this node since all of the bits match, and the answer "X" is obtained.

One of other search techniques is the one using a ternary content addressable memory (TCAM). A TCAM may be used for searching a routing table on an interface. Unlike SRAMs or SDRAMs in which a physical address is used as a key to obtain information stored in a memory location, in TCAM, the entered value is compared against a value stored in each physical address, and upon a match, the physical address of the location that contains the matched value is output.

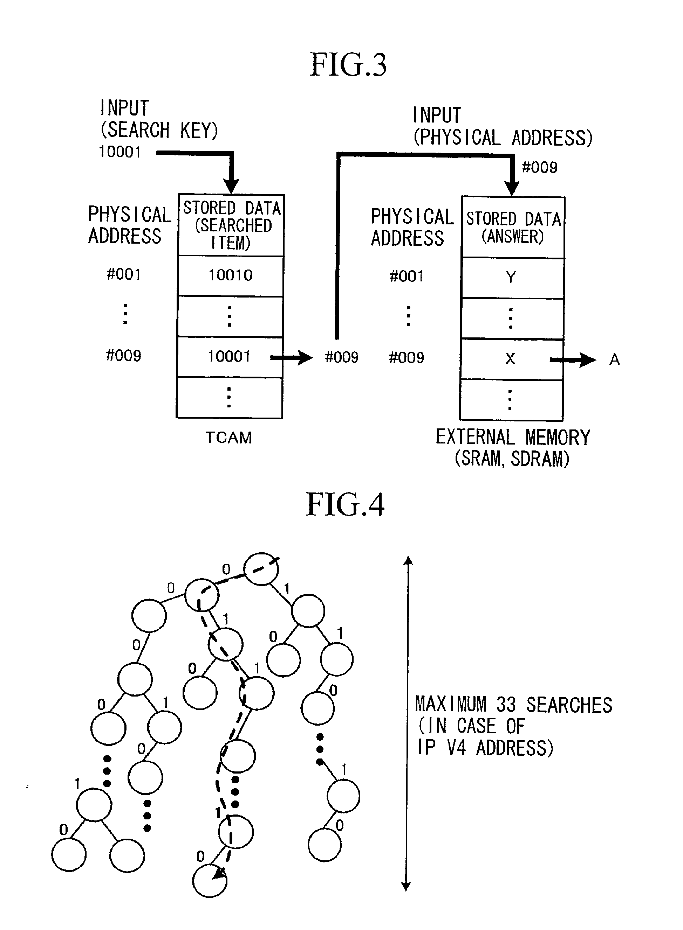

FIG. 3 illustrates an example of searching the search table shown in FIG. 1 using a TCAM. Items to be compared are stored in the TCAM and the answers corresponding to the items are stored in an external memory. In this case, a physical address of a location containing an item to be compared in the TCAM and a physical address of a location containing an answer corresponding to the item in the external memory can be mapped. In this example, a location containing an item to be compared in the TCAM has the same physical address as a location containing the answer corresponding to that item in the external memory.

As described previously, in the TCAM, an entered value is compared against a value stored in each of physical addresses, and upon a match, the physical address of the location that contains the matched value is output. In the example shown in FIG. 3, when "10001" is input as a search key, the physical address "#9" is output and the answer is obtained from the external memory using this physical address. Since with a TCAM search, all of the data stored can be searched at once in a single search, a TCAM search is significantly fast. Furthermore, a TCAM search is advantageous in that the time required for search remains constant even when the network is expanded (even when the number of the items to be searched is increased).

The depth of a tree is determined depending on the bit length of search keys to be searched. For example, if a search key is an IP v4 address, the maximum number of comparison made is 33. For an IP v6 address, the maximum number of comparison is 129. The search paths of a search using the Patricia tree is shown by dashed lines in FIG. 4. Since information contained in a node is stored in the external memory, the number of comparison is increased in proportion to the number of memory access. As the bit length of search keys is increased, and as the number of nodes in a tree is increased, the number of comparison (the number of memory access) is increased, which results in increased search time.

Furthermore, handling on a routing protocol for generating a routing table is roughly classified into the following three categories:
(1) Management of link state information: sending or receiving link state information packets that convey status on links or the network, and managing the link state information in a database
(2) Calculation of shortest paths: calculating a shortest path to a destination based on the link state information database using a shortest path algorithm, such as the Dijkstra algorithm
(3) Discovery and maintenance of neighboring routers (handling of hello packets): discovering neighboring routers and detecting failure of the neighboring routers by exchanging hello packets

Among time-consuming Items (1) and (2), searching in the link state information database takes a lot of time. Furthermore, in the conventional technique in which a search tree is used, more time is required for a search on a link state information database as the number of nodes in the tree is increased. As the size of a network managed by a single control domain is increased with a rapid penetration of the Internet in recent years, more time is required to generate a routing table or flapping of paths may occur (a shortest path is not uniquely identified and becomes unstable). Furthermore, a large network cannot built with a single control domain (see, for example, « Faster link-state IGP convergence and improved network scalability and stability », Choudhury, G. L.; Maunder, A.S.; Sapozhnikova, V.D., Local Computer Networks, 2002. Proceedings. LCN2001. 26th Annual IEEE Conference, Nov. 14th to 16th, 2001., pp. 149-158).

Document JP 2002 208945 A (FUJITSU LTD) discloses an apparatus for managing the destination information of the packets for selecting the paths of the packets is comprising a first memory, a second memory having a retrieval speed lower than the first memory and the degree of integration higher than the first memory, and a compiling section for compiling a path table storing the destination information so that the information is over the first and second memories.

Document WO 02/061625 A2 (NOKIA INTELLIGENT EDGE ROUTERS) discloses a method and a system for managing a TCAM table in which a new route is inserted into the TCAM table at an available location using an index. The new route is added into a Patricia tree organized by a mask length associated with the new route. Routes having common prefixes with the new route are searched for in patricia trees organized by longer mask lengths and in Patricia tree organized by shorter mask lengths to locate a chain for the new route. The chain for the new route groups routes having common prefixes. The routes in the chain are sequenced in an order of longer prefix first first such that a route at a top of the chain has a longest prefix. A swap of routes in the chain is preformed to accommodate the new route and to maintain the longer prefix first order.

Document SHAH D. ET AL. « Fast incremental updates on Ternary-CAMs for routing lookups and packet classification » proceedings of Hot Interconnects, XX, Y,X ....... January 2000 (2000-01-01), page 1-7, XP002958517 discloses a hardware device for performing fast routing lookups and packet classification is a ternary content-addressable memory (TCAM) in which a TCAM searches the header of the incoming packet against all entries in the forwarding table or the classifier database in parallel. It keeps the entries in decreasing order of priority of the rules in a classifier, or prefix lengths of the entries in a forwarding table. Keeping the list sorted under addition and deletion of rules in the classifier is an expensive operation, and may take O(N) memory shift (write) operations in the worst case, where N is the number of rules in the classifier (or prefixes in the forwarding table).

### DISCLOSURE OF THE INVENTION

The present invention was conceived in view of the above-described background, and an object thereof is to solve the problem of difficulty in building a large network using a single control domain since moretime is required to generate a routing table as the size of the network is increased.

The present invention is a routing table generating unit that generates a routing table describing a next hop to which a packet is to be sent according to a destination address of the packet that is input via an input channel.

The routing table generating unit further comprises
- a ternary content addressable memory TCAM;
- a unit that classifies items in information that is received, and a unit that stores an item that uniquely identifies the information among the classified items in the TCAM
a second memory separated from said ternary content addressable memory TCAM and dedicated to store at least a portion of item in the received information.

According to the invention, the routing table generating unit is characterized by
a unit adapted to search the information stored in the TCAM using, as a search key, the item that uniquely identifies the information among the classified items, upon receiving new information, prior to storing the new information,
a unit adapted to initiate the storing process by the storing unit when the item that uniquely identifies the newly received information and the item that uniquely identifies the information that has been stored in the TCAM do not match in the search; and
a unit adapted to determine whether the newly received information is older than corresponding information stored in the second memory that corresponds to the item that uniquely identifies the newly received information, when the item that uniquely identifies the newly received information and the item that uniquely identifies the information that has been stored the TCAM match in the search.

By this, the speed of a search is increased since only the TCAM that stores items that uniquely identify the information is searched when the information stored is searched.

The routing table generating unit may further include: a unit that ignores the newly received information, when it is determined by the comparing unit that the newly received information is as old as or older than the corresponding information stored in the external memory; and a unit that, when it is determined by the comparing unit that the newly received information is newer than the corresponding information stored in the external memory, updates the corresponding information stored in the external memory with the newly received information.

By this, the processing load can be reduced since the updating is not executed when the newly received information is as old as or older than the corresponding information stored in the external memory. Furthermore, memory can be used effectively since redundant information is not stored.

The routing table generating unit may further include a unit that, upon an arrival of an arrived packet, searches for a shortest path using the information stored in the TCAM and the information stored in the external memory based on a destination address of the arrived packet.

By this, hardware can be effectively utilized since generation of routing tables and search of the shortest path can be executed by an information processing unit in a single device.

The routing table generating unit may further include a unit that determines a next hop to which the arrived packet is to be sent based on the search of the shortest path.

Another form of the present invention is a program used in a routing table generating unit that generates a routing table describing a next hop to which a packet is to be sent according to a destination address of the packet that is input via an input channel.

The program, when installed in a computing device, providing the computing device with the functions equivalent to those of an LSDB search unit, includes: a function that classifies items in information that is received; and a function that stores an item that uniquely identifies the information among the classified items in a ternary content addressable memory, TCAM, and stores the rest of the items in a second memory separated from said TCAM and dedicated to store at least of item in the received information.

The program is characterized by a function that, upon receiving new information, prior to storing the new information, searches the information stored in the TCAM using, as a search key, the item that uniquely identifies the information among the classified items; a function that initiates the storing process by the storing function when the item that uniquely identifies the newly received information and the item that uniquely identifies the information that has been stored in the TCAM do not match in the search; and a function that, when the item that uniquely identifies the newly received information and the item that uniquely identifies the information that has been stored in the TCAM match in the search, determines whether the newly received information is older than corresponding information stored in the external memory that corresponds to the item that uniquely identifies the newly received information.

The program further provides a function that ignores that newly received information, when it is determined by the comparing function that the newly received information is as old as or older than the corresponding information stored in the external memory; and a function that, when it is determined by the comparing function that the newly received information is newer than the corresponding information stored in the external memory, updates the corresponding information stored in the external memory with the newly received information.

The program further provides a function that, upon an arrival of an arrived packet, searches for a shortest path using the information stored in the TCAM and the information stored in the external memory based on a destination address of the arrived packet. The program further provides a function that determines a next hop to which the arrived packet is to be sent based on the search of the shortest path.

By this, a routing table generating unit that generates routing tables in a shortened time and enables the formation of a large network with a single control domain can be realized using an ordinary computing device.

Another aspect of the present disclosure is an LSDB search unit that is provided in an interface that processes a packet that is input via an input channel, provided in a packet transfer device. The other aspect of the present disclosure is characterized in that it includes a link state database (LSDB) search unit that is provided in an interface that processes a packet that is input via an input channel, provided in a packet transfer device, including: a unit that collects received information using a control packet of a routing protocol; a unit that stores at least a portion of items in the received information collected; and a unit that compares the stored information and information on the at least a portion of item in newly received information collected by the collecting unit to determine whether the newly received information is new or old. By this, a determination can be made as to whether or not received information is new.

The LSDB search unit may further include a unit that, upon an arrival of a newly arrived control packet containing the newly received information, transfers the newly arrived control packet containing the newly received information to a routing device when information on the at least a portion of item in the newly received information is newer than the information stored based on the decision made by the comparing unit, and discards the newly arrived control packet containing the newly received information when the information on the at least a portion of item in the newly received information is as old as or older than the information stored.

By this, since only new information is selected and processed, the processing load of an RS can be reduced, and a large network can be built with a single control domain, which is impossible with conventional techniques.

Alternatively, the LSDB search unit may further include a unit that transfers the information on the at least a portion of item in the control packet that has been transferred to the routing device to an LSDB search unit in another interface when the information on the at least a portion of item in the newly received information is newer than the information stored based on the decision made by the comparing unit.

The LSDB search unit may further include a unit that, upon an arrival of a newly arrived control packet containing the newly received information, transfers information on at least a portion of item in the newly arrived control packet containing a newly received information to an LSDB search unit in another interface when the information on the at least a portion of item in the newly received information is newer than the information stored based on the decision made by the comparing unit; and a unit that stores information on at least a portion of item in a control packet that is transferred from another unit.

By this, only new information is selected and can be shared among a plurality of LSDB search units.

Another form of the other aspect of the present disclosure is a program used in a link state database (LSDB) search unit that is provided in an interface that processes a packet that is input via an input channel, provided in a packet transfer device, including: the program, when installed in a computing device, providing the computing device with the functions equivalent to those of an LSDB search unit, including: a function that collects received information using a control packet of a routing protocol; a function that stores at least a portion of the received information collected; and a function that compares the stored information and at least a portion of the newly received information collected by the collecting function to determine whether the newly received information is new or old.

The program further provides a function that, upon an arrival of a newly arrived control packet containing the newly received information, transfers the newly arrived control packet containing the newly received information to a routing device when information on at least a portion of item in the newly received information is newer than the information stored based on the decision made by the comparing function, and discards the newly arrived control packet containing the newly received information when the information on the at least a portion of item in the newly received information is as old as or older than the information stored.

The program may further provide a function that transfers the information on the at least a portion of item in the control packet that has been transferred to the routing device to an LSDB search unit in another interface when the at least a portion of the information in the newly received information is newer than the information stored based on the decision made by the comparing function.

The program may further provide: a function that, upon an arrival of a newly arrived control packet containing the newly received information, transfers information on at least a portion of item in a newly arrived control packet containing the newly received information to an LSDB search unit in another interface when information on the at least a portion of the item in the newly received information is newer than the information stored based on the decision made by the comparing function; and a function that stores information on at least a portion of item in a control packet that is transferred from another function.

Furthermore, another form of the other aspect of the present disclosure is a recording medium readable from the computing device, which records the program according to the present invention. Since the program of the present invention is stored in the recording medium of the present invention, the program of the present invention can be installed in the computing device using this recording medium. Alternatively, the program of the present invention can be installed directly into the computing device from a server that has the program of the present invention via a network.

By this, an LSDB search unit that generates routing tables in a shortened time and enables the formation of a large network with a single control domain can be realized by reducing the processing load of the RS within a packet transfer device using an ordinary computing device.

### BRIEF DESCRIPTION OF THE DRAWINGS

FIG. 1 is a diagram illustrating a conventional search table.
FIG. 2 is a diagram illustrating a conventional search technique using a Patricia tree.
FIG. 3 is a diagram illustrating a search technique using TCAM.
FIG. 4 is a diagram illustrating a search path when the Patricia tree is used.
FIG. 5 is a schematic diagram illustrating a routing table generating unit of a first embodiment of the present invention.
FIG. 6 is a schematic diagram illustrating a conventional packet transfer device.
FIG. 7 is a diagram illustrating a first exemplary configuration of the packet transfer device according to the first embodiment of the present invention.
FIG. 8 is a diagram illustrating a second exemplary configuration of the packet transfer device according to the first embodiment of the present invention.
FIG. 9 is a diagram illustrating a third exemplary configuration of the packet transfer device according to the first embodiment of the present invention.
FIG. 10 is a diagram illustrating a fourth exemplary configuration of the packet transfer device according to the first embodiment of the present invention.
FIG. 11 is a diagram illustrating a format of the router LSA.
FIG. 12 is a diagram illustrating a format of a network LSA.
FIG. 13 is a diagram of an exemplary network for illustrating the operations of the information processing unit of the first embodiment of the present invention.
FIG. 14 is a diagram illustrating items stored in a TCAM and external memory according to the first embodiment of the present invention.
FIG. 15 is a diagram illustrating operations for receiving an LSA according to the first embodiment of the present invention.
FIG. 16 is a diagram illustrating operations for calculating an SPF according to the first embodiment of the present invention.
FIG. 17 is a diagram illustrating a search model of the first embodiment of the present invention.
FIG. 18 is a graph showing results of the simulation in which the search model shown in FIG. 17 is used.
FIG. 19 is a schematic diagram illustrating a packet transfer device that includes an LSDB search unit according to a first example of the second embodiment of the present invention.
FIG. 20 is a schematic diagram illustrating the LSDB search unit according to the first example of the second embodiment of the present invention.
FIG. 21 is a schematic diagram illustrating a packet transfer device that includes an LSDB search unit according to a second example of the second embodiment of the present invention.
FIG. 22 is a schematic diagram illustrating the LSDB search unit according to the second example of the second embodiment of the present invention.
FIG. 23 is a diagram illustrating the format of the router LSA, which is a type of LSA for describing information on a packet transfer device.
FIG. 24 is a diagram illustrating the format of a network LSA, which is a type of LSA for describing network information.
FIG. 25 is a diagram of an exemplary network for illustrating examples of information to be stored in the LSDB search unit and operations of the information processing unit.
FIG 26 is a diagram illustrating information stored in the LSDB search unit shown in FIG 25.
FIG 27 is a diagram illustrating operations of the LSDB search unit upon receiving an LSA.
FIG. 28 is a diagram illustrating a first exemplary configuration of a conventional packet transfer device.
FIG 29 is a diagram illustrating a second exemplary configuration of a conventional packet transfer device.

### BEST MODE FOR CARRYING OUT THE INVENTION

Preferred embodiments of the invention will be described with reference to the drawings. However, it should not be construed that the present invention is limited to these embodiments; rather, components of these embodiments, for example, may be combined if necessary.

### <First Embodiment >

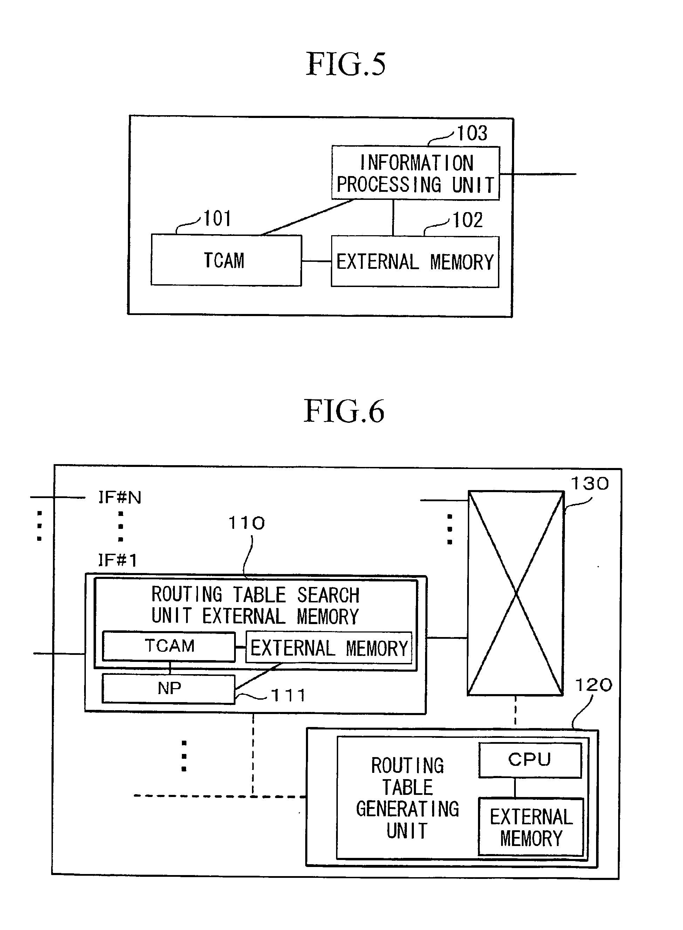

A first embodiment of the present invention is a routing table generating unit. This routing table generating unit will be described with reference to FIGS. 5 to 16. FIG. 5 is a schematic diagram illustrating a routing table generating unit of a first embodiment of the present invention.

The first embodiment of the present invention is a routing table generating unit that generates a routing table describing a next hop to which a packet is to be sent according to a destination address of the packet that is input via an input channel.

Here, the first embodiment of the present invention is characterized in that it includes a TCAM 101, an external memory 102, and an information processing unit 103 that is provided with a unit that classifies items in information that is received and a unit that stores an item that uniquely identifies the information among the classified items in the TCAM and stores the rest of the items to the external memory, as shown in FIG. 5.

In addition, the information processing unit 103 further includes a unit that, upon receiving new information, prior to storing the new information, searches the information stored in the TCAM 101 using, as a search key, the item that uniquely identifies the information among the classified items; a unit that initiates the storing process by the storing unit when the item that uniquely identifies the newly received information and the item that uniquely identifies the information that has been stored in the TCAM 101 do not match in the search; and a unit that, when the item that uniquely identifies the newly received information and the item that uniquely identifies the information that has been stored in the TCAM 101 match in the search, determines whether the newly received information is older than corresponding information stored in the external memory 102 that corresponds to the item that uniquely identifies the newly received information.

Furthermore, the information processing unit 103 further include a unit that ignores the newly received information, when it is determined by the comparing unit that the newly received information is as old as or older than the corresponding information stored in the external memory 102; and a unit that, when it is determined by the comparing unit that the newly received information is newer than the corresponding information stored in the external memory 102, updates the corresponding information stored in the external memory 102 with the newly received information.

In addition, the information processing unit 103 further includes a unit that, upon an arrival of an arrived packet, searches for a shortest path using information stored in the TCAM 101 and the external memory 102 based on a destination address of the arrived packet. The information processing unit 103 further includes a unit that determines a next hop to which the arrived packet is to be sent based on the search of the shortest path.

In addition, the first embodiment of the present invention may be embodied as a program which, when installed in a common computing device, provides the computing device with functions that are equivalent to each unit in the routing table generating unit of the present invention. The program may be recorded in a recording medium and be installed in a computing device, or may be installed in the computing device via a communication channel, thereby providing that computing device with functions that are equivalent to those of the information processing unit 103.

Hereinafter, the first embodiment of the present invention will be described in more detail.

The routing table generating unit of the present embodiment includes the information processing unit 103, the TCAM 101, and the external memory 102, as shown in FIG. 5. The information processing unit 103 executes necessary processing on information exchanged or collected using a routing protocol, such as the OSPF, the ISIS, or the like. Such processing includes, classifying items in the information, storing items that uniquely identify the information into the TCAM 101, and storing necessary items among the rest of the items (hereinafter referred to as "link state information") into the external memory 102; extracting the item that uniquely identifies the information from the received information, entering the items to the TCAM 101, searching TCAM 101 and storing information into the external memory 102 according to the result of the search; and updating the information. In addition, the information processing unit 103 has a function to calculate a shortest path using the TCAM 101 and the external memory 102 and transfer the routing table to a routing table search unit.

FIG. 6 illustrates a conventional packet transfer device. The packet transfer device includes a route server (RS) 120, a switch (SW) 130, and an interface (IF: channel). The RS 120 processes a routing protocol, such as the OSPF, the ISIS, or the like, to generate a routing table, and the RS 120 transfers the generated routing table to the routing table search unit 110 in the IF.

When a packet is input via an input channel, a network processor (NP) 111 extracts destination address information, and a routing table search unit 110 determines the next hop (next router) according to the shortest path to the destination for determining an IF to which the packet is to be sent.

Hereinafter, four exemplary configurations of a packet transfer device including the routing table generating unit according to the first embodiment of the present invention will be described.

### (First Exemplary Configuration)

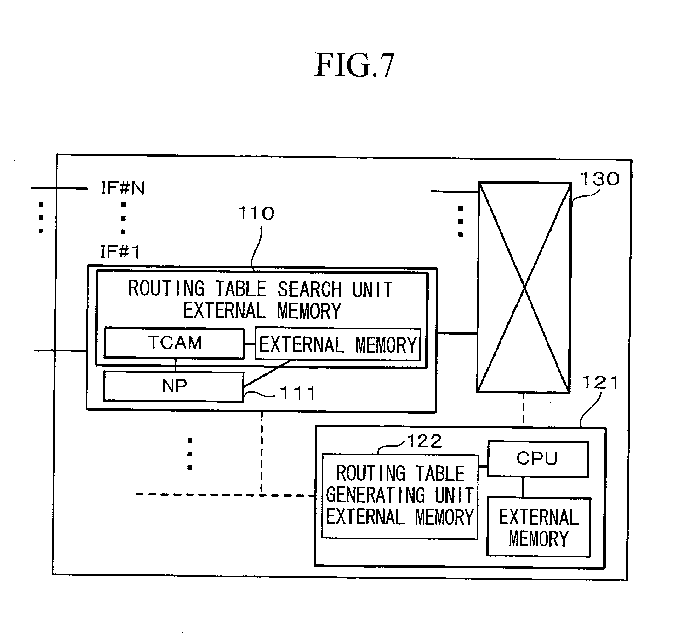

FIG. 7 illustrates a first exemplary configuration of the routing table generating unit according to the first embodiment of the present invention. In the first exemplary configuration, a routing table generating unit 122 of this embodiment is provided in the RS 121. In this configuration, the routing table generating unit 122 that uses such information is provided in the RS 121 since the RS 121 processes a routing protocol, such as the OSPF, the ISIS, or the like. Since the routing table generating unit 122 is provided in the RS 121, this configuration is advantageous in that information required by the routing table generating unit 122 is easily provided to the routing table generating unit 122.

### (Second Exemplary Configuration)

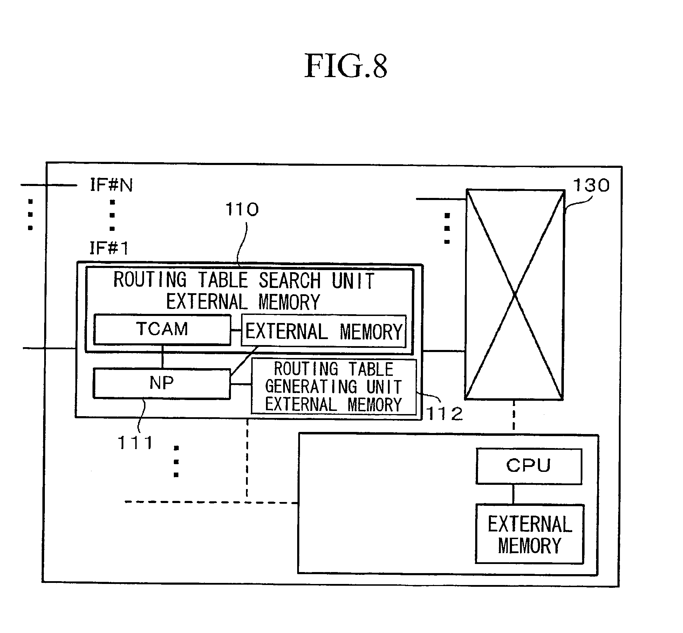

FIG. 8 illustrates a second exemplary configuration of the routing table generating unit according to the first embodiment of the present invention. In the second exemplary configuration, the routing table generating unit 112 is provided in the IF. This configuration is advantageous in that the routing tables generated by the routing table generating unit 112 are transferred to the routing table search unit 110 and transfer of the routing tables are easily done.

### (Third Exemplary Configuration)

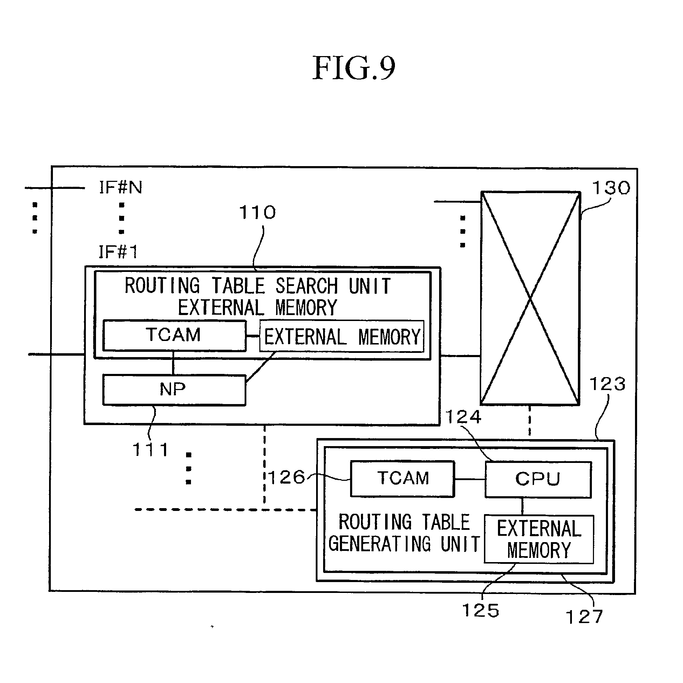

FIG. 9 illustrates a third exemplary configuration of the routing table generating unit according to this embodiment. In this exemplary configuration, an RS 123 is simply added to the TCAM 101. The RS 123 is equipped with a CPU 124 that functions as the information processing unit 103 of the routing table generating unit of the present embodiment shown in FIG. 5 and an external memory 125 that functions as the external memory 102. The routing table generating unit 127 can be embodied by utilizing the CPU 124 as the information processing unit 103, and adding the external memory 125 and a TCAM 126. This example is advantageous in terms of implementation cost because the CPU 124 and the external memory 125 that are equipped in the RS 123 are used.

### (Fourth Exemplary Configuration)

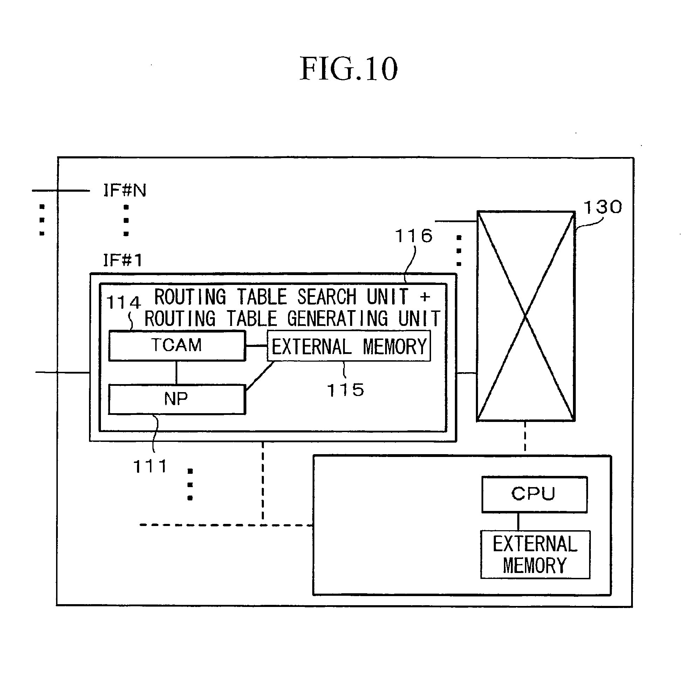

FIG. 10 illustrates a fourth exemplary configuration of the routing table generating unit according to this embodiment. The NP 111 has a processing function, which is employed as the information processing unit 103 shown in FIG. 5. The TCAM 114 and the external memory 115 that is intended to be used for the routing table search unit 116 are employed as the TCAM 101 and the external memory 102 shown in FIG. 5. In this manner, a routing table generating unit is configured. This example is advantageous in terms of implementation cost because the processor that is equipped in the NP 111 and the external memory 115 that is equipped in the NP 111 are used.

### (Fifth Exemplary Configuration)

Hereinafter, the information stored in the TCAM 101 and the external memory 102, and operations of the information processing unit 103 will be explained using the OSPF as a routing protocol. Under the OSPF, information on packet transfer devices on the network and the information on the network are exchanged and collected between the packet transfer devices or between routing table generating units in a network using packets called "link state updates (LSUs)." LSUs are classified into five data types called link state advertisements (LSA) for describing information on a packet transfer device or information on a network, or the like.

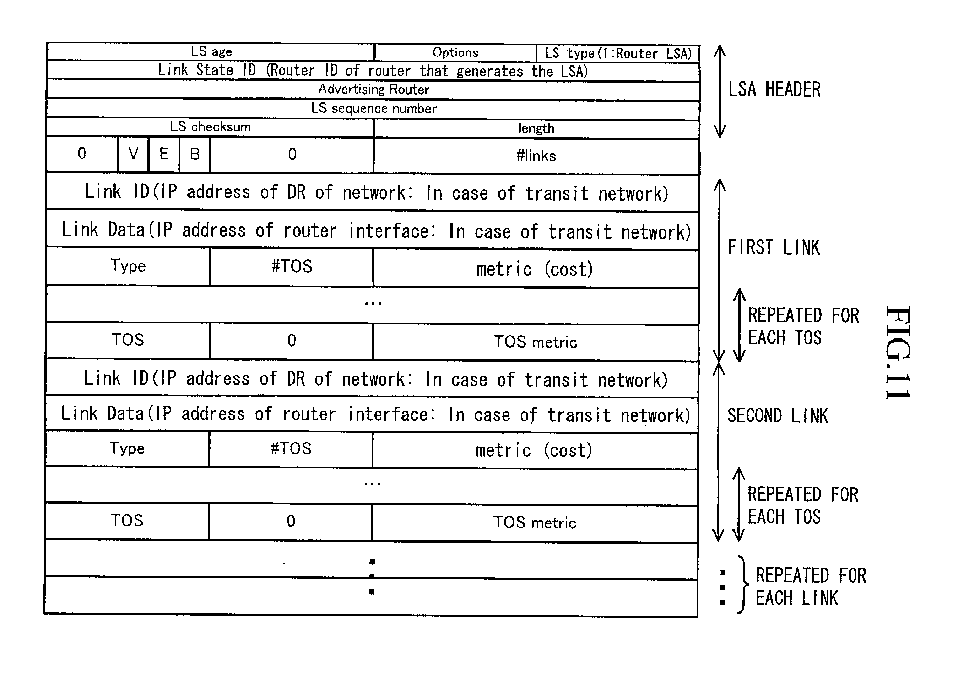

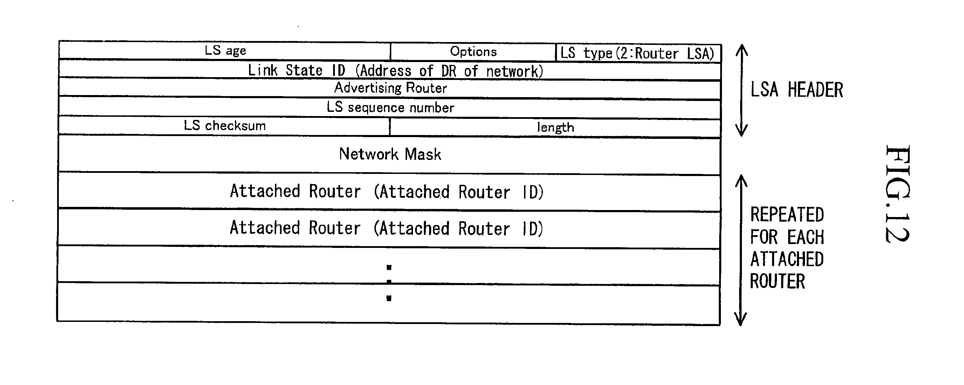

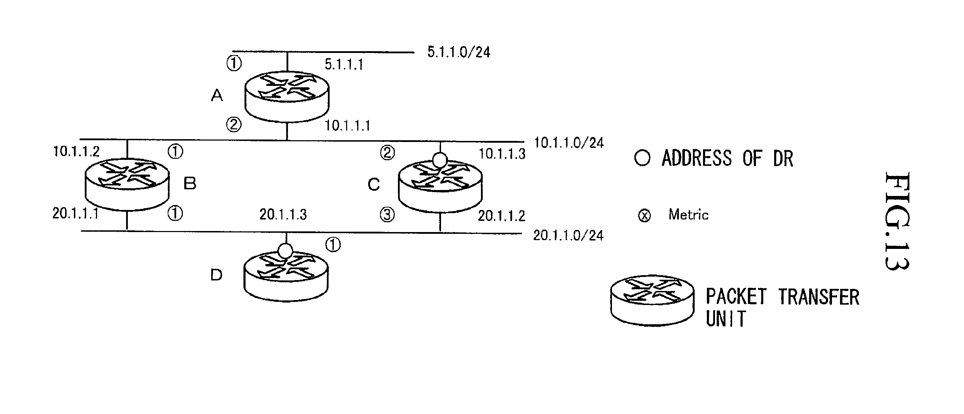

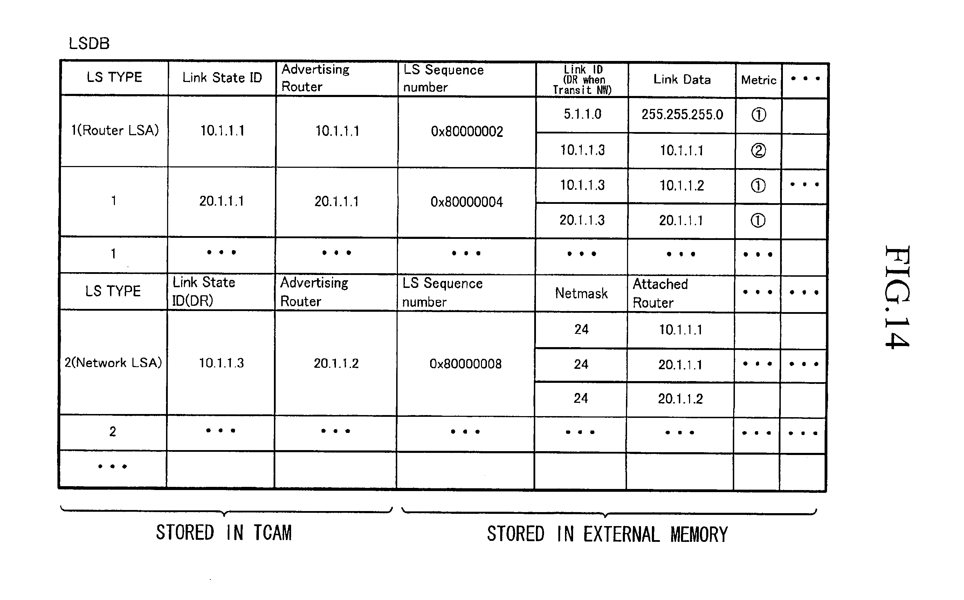

FIG. 11 illustrates the format of the router LSA, which is a type of LSA for describing information on a packet transfer device. FIG. 12 illustrates the format of the network LSA, which is a type of LSA for describing network information. FIG. 13 illustrates an exemplary network for illustrating examples of information to be stored in the TCAM and the external memory and operations of the information processing unit. FIG. 14 illustrates the information collected and stored in the TCAM and the external memory as a link state database (LSDB), i.e., a database of the LSA information collected in the example shown in FIG. 13.

Since an LSA is uniquely identified by an LS type, a link state ID, and an advertising router, the LS type, the link state ID, and the advertising router are stored in the TCAM as items that uniquely identify information, and the rest of the information is stored in the external memory as link state information.

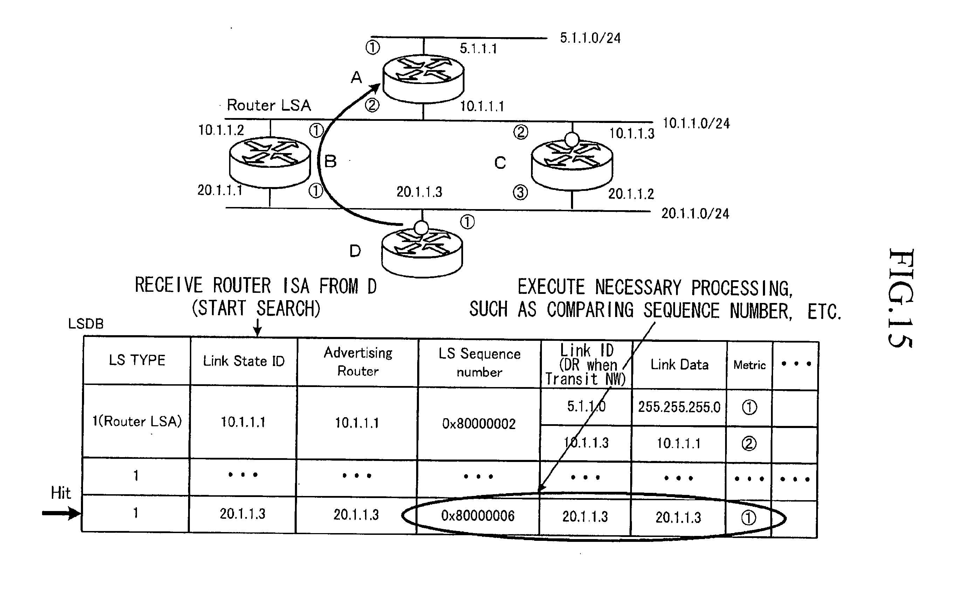

FIG. 15 illustrates operations of the LSDB search unit upon receiving an LSA. When an LSA is received, a determination is made as to whether data in the LSA has been stored in the TCAM based on the LS type, the link state ID, and the advertising router of the received LSA. If no match is found in the TCAM, the LSA is a new LSA and is stored in the LSDB (a portion of the information is the TCAM, and the rest of the information is stored in the external memory). If corresponding data is found in the LSDB, a hit occurs in the TCAM. Other information is obtained from the external memory, and necessary processing, such as comparison of the sequence numbers, is carried out.

In the example shown in FIG. 15, it is assumed that Packet transfer device A receives a router LSA from Packet transfer device D. A hit occurs in the TCAM in this example. Other information is obtained from the external memory, and necessary processing, such as comparison of the sequence numbers, is executed.

The necessary processing includes, for example, comparing the sequence number of the received LSA and a sequence number of the information that has been stored in the external memory; ignoring the newly received LSA when it is determined as a result of the comparison that the newly received LSA is older than or as old as the information that has been stored in the external memory; updating the information that has been stored in the external memory with the newly received LSA when it is determined as a result of the comparison that the newly received LSA is newer than the information that has been stored in the external memory.

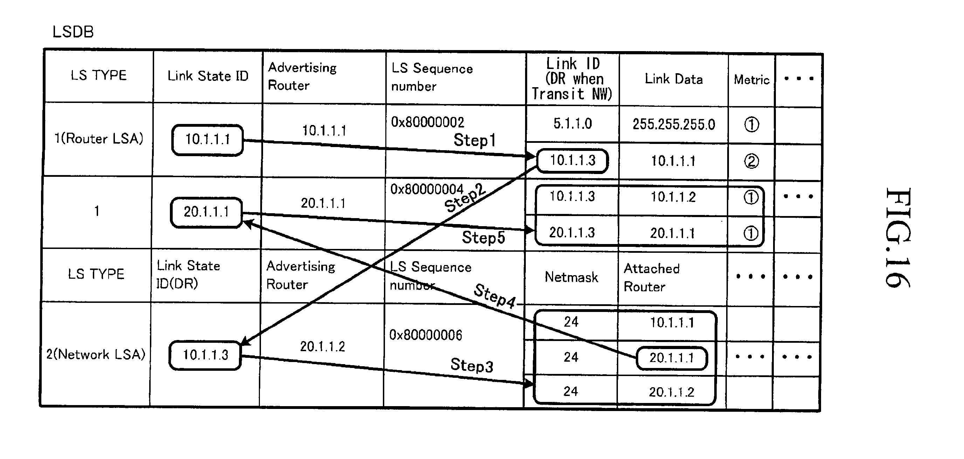

In addition, FIG. 16 illustrates an example technique for calculating the shortest path by Router A. The network configuration information may be obtained from the steps described below. The shortest path may be determined using the Dijkstra algorithm based on the network configuration information.
Step 1: The DR (designated router) address of the network is determined from the link state ID of the router that executes the calculation.
Steps 2 and 3: An attached router in the network (the routers that access that network) and the net mask information of the network is obtained from a network LSA using the DR address as a search key. By this, the network and the routers accessing to the network are determined.
Steps 4 and 5: Information on attached routers (IP addresses or metrics of the links, or the like) is obtained from the router LSA using the addresses of the attached routers as keys. By this, link information of the routers is determined and the router of the next hop is determined.

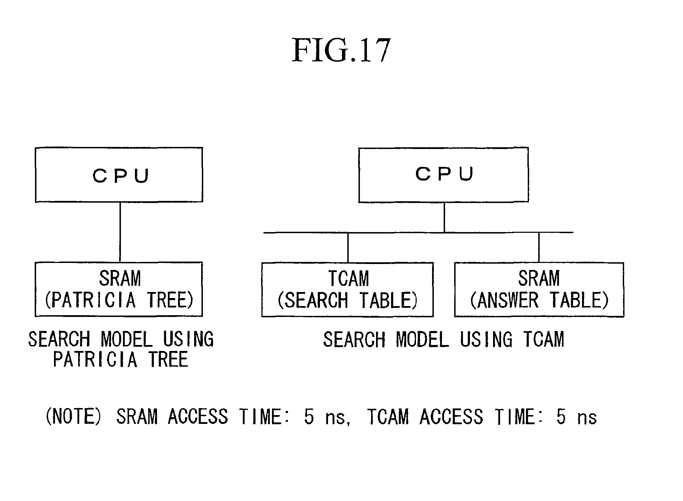

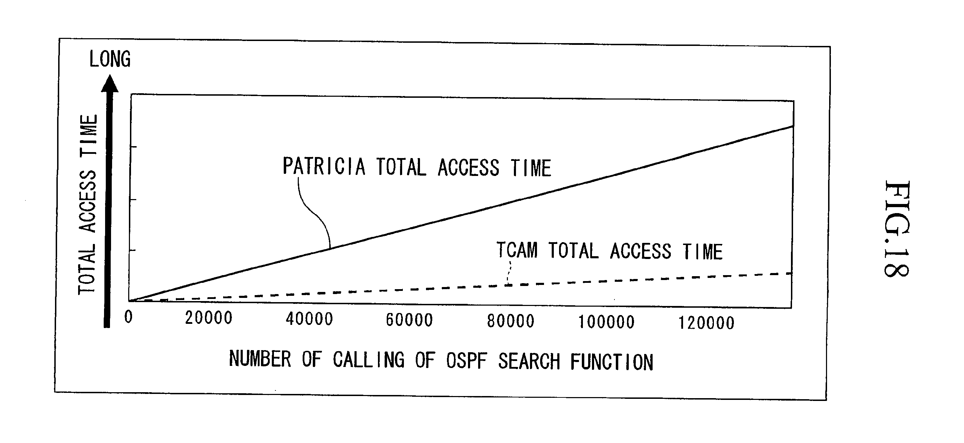

The effectiveness of the present invention was evaluated using the simulation under the following conditions. Performances of the search using a simple search model as shown in FIG. 17 using the Patricia tree and the TCAM were compared. It was assumed that the code segment that calls a search function (the search technique employed was assumed to be Patricia tree) from the OSPF was replaced by the code segment that simply accesses the TCAM. In the simulation, access speeds of commercially available SRAMs and TCAMs (5 ns, respectively) were used. The CPU processing time was not considered and the comparison was made only based on the memory access time. However, it is apparent that the Patricia tree search requires longer CPU processing time since every piece of data is required to be searched from the top node of the tree in the Patricia tree search, whereas in the TCAM search, data is obtained by a single comparison after entering the data in the TCAM. Estimated time required for searches on LSAs when 10,000 LSAs were sent was compared between the Patricia tree search and the TCAM search, and the results are shown in FIG. 18. The difference in the access time between the Patricia tree search and the TCAM search increases as more access occurs, and eventually the total access time of the TCAM search became about one-sixth of the total access time of the Patricia tree search.

As described above, the first embodiment of the present invention accelerates the generation of routing tables, and enables formation of a large network with a single control domain.

### <Second Embodiment>

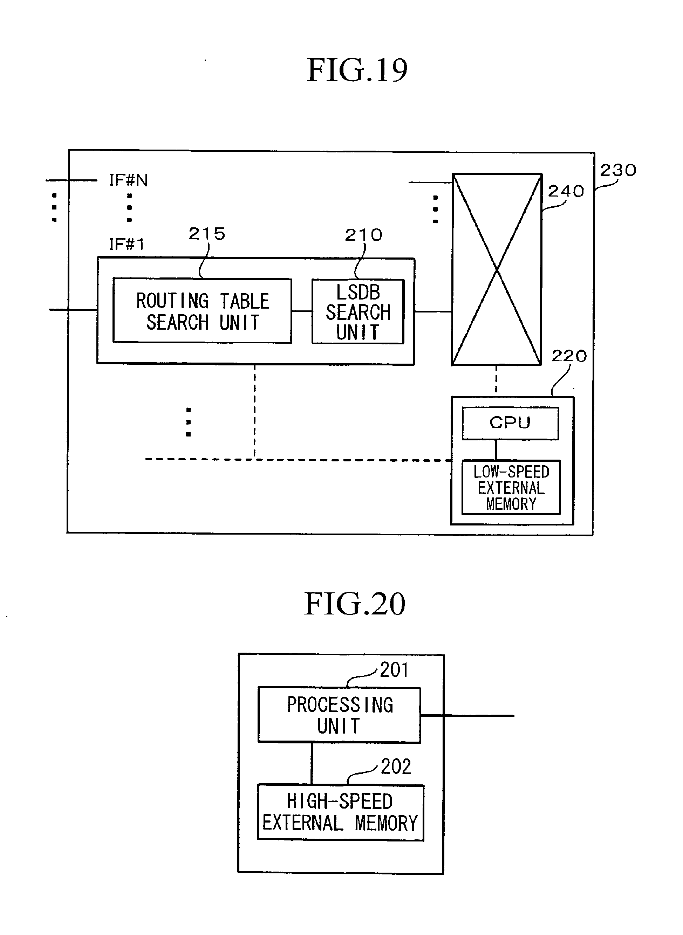

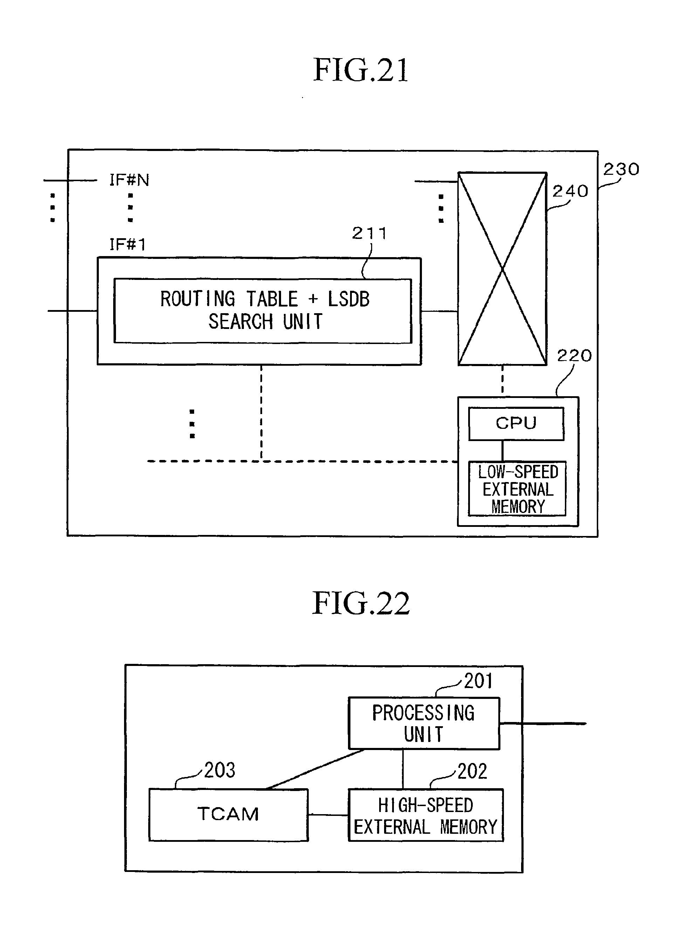

A second embodiment of the present invention is an LSDB search unit This LSDB search unit will be described with reference to FIGS. 19 to 22. FIG. 19 is a schematic diagram illustrating a packet transfer device that includes an LSDB search unit according to a first example of the second embodiment of the present invention. FIG 20 is a schematic diagram illustrating the LSDB search unit according to the first example of the second embodiment of the present invention. FIG. 21 is a schematic diagram illustrating a packet transfer device that includes an LSDB search unit according to a second example of the second embodiment of the present invention. FIG. 22 is a schematic diagram illustrating the LSDB search unit according to the second example of the second embodiment of the present invention.

The second embodiment of the present invention is an LSDB search unit 210 that is provided in an interface that processes a packet that is input via an input channel, provided in a packet transfer device 230, as shown in FIG 19. The present embodiment is characterized in that it includes an information processing unit 201 that collects the received information using a control packet of a routing protocol; a high-speed external memory 202 that stores at least a portion of item in the received information collected, and that information processing unit 201 includes a unit that compares the information stored in the high-speed external memory 202 and information on the at least a portion of item in newly received information to determine whether the received information is new or old, as shown in FIG. 20.

In addition, the information processing unit 201 further includes a unit that, upon an arrival of a newly arrived control packet containing the newly received information, transfers the newly arrived control packet containing the newly received information to the RS 220 when the information on the at least a portion of item in the newly received information is newer than the information stored based on the decision made by the comparing unit, and discards the newly arrived control packet containing the newly received information when the information on the at least a portion of item in the newly received information is as old as or older than the information stored.

In addition, the information processing unit 201 includes a unit that transfers the at least a portion of the information in the control packet that has been transferred to the RS 220 to an LSDB search device in another interface when the information on the at least a portion of item in the newly received information is newer than the information stored based on the decision made by the comparing unit.

In addition, the information processing unit 201 further includes a unit that, upon an arrival of a newly arrived control packet containing the newly received information, transfers information on at least a portion of item in a newly arrived control packet containing the newly received information to an LSDB search device in another interface when the information on the at least a portion of item in the newly received information is newer than the information stored based on the decision made by the comparing unit; and a unit that stores information on at least a portion of item in a control packet that is transferred from another unit.

In addition, the present invention may be embodied as a program which, when installed in a common computing device, provides with the computing device functions that are equivalent to each units in the LSBD search unit of the present invention. The program may be recorded in a recording medium and be installed in a computing device, or may be installed in the computing device via a communication channel, thereby providing that computing device with functions that are equivalent to those of the information processing unit 201.

The packet transfer device shown in FIG. 21 includes the LSDB search unit shown in FIG. 22. In the packet transfer device shown in FIG. 21, the routing table search unit and the LSDB search unit are implemented in a single LSDB search unit 211.

### (First Example)

FIG. 20 is a diagram illustrating the LSDB search unit according to a first example of the second embodiment of the present invention. The LSDB search unit 210 of the first example shown in FIG. 19 includes an information processing unit 201 and a high-speed external memory 202. In this example, LSDBs are searched using a tree search technique, such as the Patricia tree. A portion of the items in a control packet received by the LSDB search unit 210 is transferred to the RS 220. The information processing unit 201 classifies the items in the received information and generates a search tree based on items that uniquely identify the information. The items that uniquely identify the information, the structural information of the tree, and information that is used to determine whether or not control messages are new (hereinafter referred to as "LS sequence number") are stored in this tree.

In addition, once the portion of the items in the control packet received by its own interface is stored in the LSDB search unit 210, the LSDB search unit 210 transfers the portion of the items in the control packet that is stored to another interface. Furthermore, a portion of items in a control packet received by another interface is transferred to the LSDB search unit 210 by an LSDB search unit in the another interface. Thus, LSDB search units 210 in all of the interfaces can share the latest information.

When a control packet of a routing protocol, such as the OSPF, the ISIS, or the like, is input via an input channel, the information processing unit 201 extracts items that uniquely identify the information and an LS sequence number from items in information in the control packet, and search them in the search tree. The items that uniquely identify the information in the control packet are entered as an searched item, and then the search is executed. If a match is found in the search, the LS sequence number of the input control packet and the LS sequence number contained in the tree, which is the answer, are compared, and when the information in the input control packet is not new (the information is as old as or older than the information that has been received), the control packet is discarded. When the information in the input control packet is new, the control packet is transferred to the RS.

In addition, when the information in the input control packet is new, the items that uniquely identify the information and the LS sequence number of the control packet are stored in the LSDB search unit 210 in the interface that receives the control packet, and a search tree is created based on the items that uniquely identify the information. This LSDB search unit 210 then transfers the items that uniquely identify the information and the LS sequence number of the control packet to all of the interfaces other than its own interface. In addition, the LSDB search unit 210 stores items that uniquely identify information in a control packet and an LS sequence number that are received from another interface. Thus, LSDB search units 210 in all of the interfaces can share the latest information.

### (Second Example)

FIG. 22 is a diagram illustrating the LSDB search unit according to a second example of the second embodiment of the present invention. The LSDB search unit 211 of the second example includes an information processing unit 201, a TCAM 203, and a high-speed external memory 202. In the second example, LSDBs are searched using the TCAM 203. A portion of the items in a control packet received by the LSDB search unit 211 is transferred to the RS 220. The information processing unit 201 classifies items in the received information, and stores the items that uniquely identify the information into the TCAM 203, and the LS sequence number that is used to determine whether the control message is the newest is stored in the high-speed external memory 202.

In addition, once the LSDB search unit 211 stores the portion of the items in the control packet received by its own interface, the LSDB search unit 211 transfers the portion of the items in the control packet that is stored to other interfaces. Furthermore, the LSDB search unit 211 stores a portion of items in a control packet transferred from another interface. Thus, LSDB search units 211 in all of the interfaces can share the latest information.

When a control packet of a routing protocol, such as the OSPF, the ISIS, or the like, is input via an input channel, the information processing unit 201 extracts items that uniquely identify the information and an LS sequence number from the items in information in the control packet, and search them in the TCAM 3. The items that uniquely identify the information in the control packet are entered as an searched item into TCAM 203, and then the search is executed.

If a match is found in the search, the LS sequence number of the input control packet and the LS sequence number contained in the high-speed external memory 202, which is the answer, are compared, and when the information in the input control packet is not new (the information is as old as or older than the information that has been received), the control packet is discarded. When the information in the input control packet is new, the control packet is transferred to the RS 220.

In addition, when the information in the input control packet is new, the LSDB search unit 211 in the interface that receives the control packet stores the items that uniquely identify the information of the control packet and the LS sequence number, and creates a search tree based on the items that uniquely identify the information. This LSDB search unit 211 then transfers the items that uniquely identify the information of the control packet and the LS sequence number to all of the interfaces other than its own interface. In addition, the LSDB search unit 211 stores items that uniquely identify information in a control packet and an LS sequence number that is received from another interface. Thus, LSDB search units 211 in all of the interfaces can share the latest information.

### (Third Example)

Hereinafter, information stored in the LSDB search unit and operations of the information processing unit will be explained using the OSPF as a routing protocol. Under the OSPF, information on packet transfer devices on the network and the information on the network are exchanged and collected between the packet transfer devices or between routing table generating units in a network using packets called "link state updates (LSUs)." LSUs are classified into five data types called link state advertisements (LSA) for describing information on a packet transfer device or information on a network, or the like.

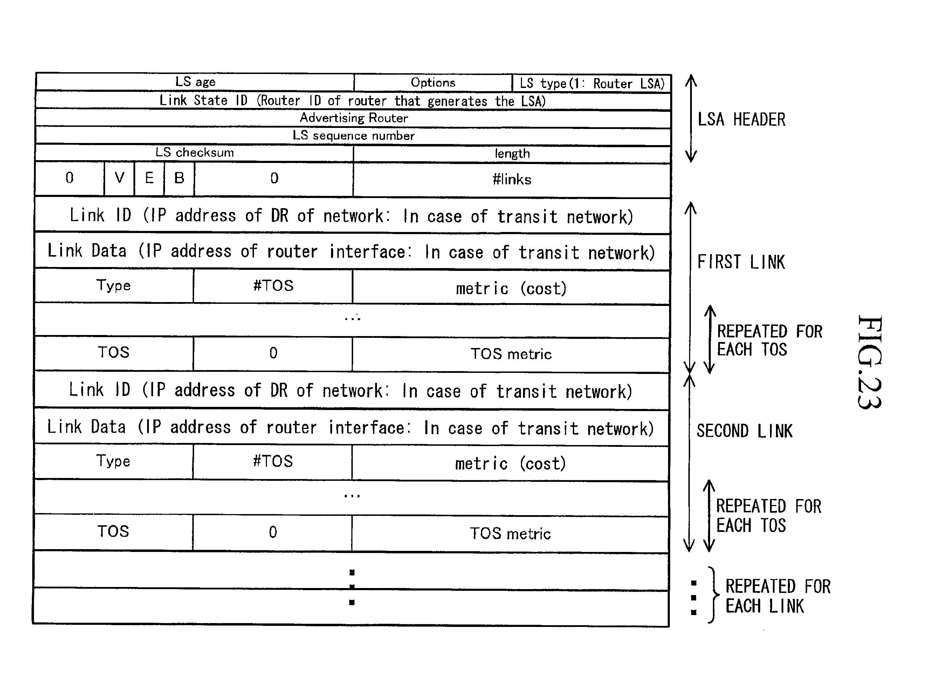

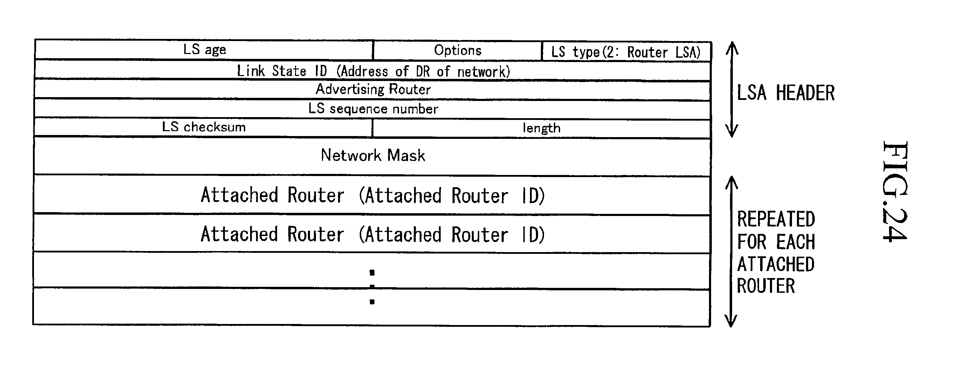

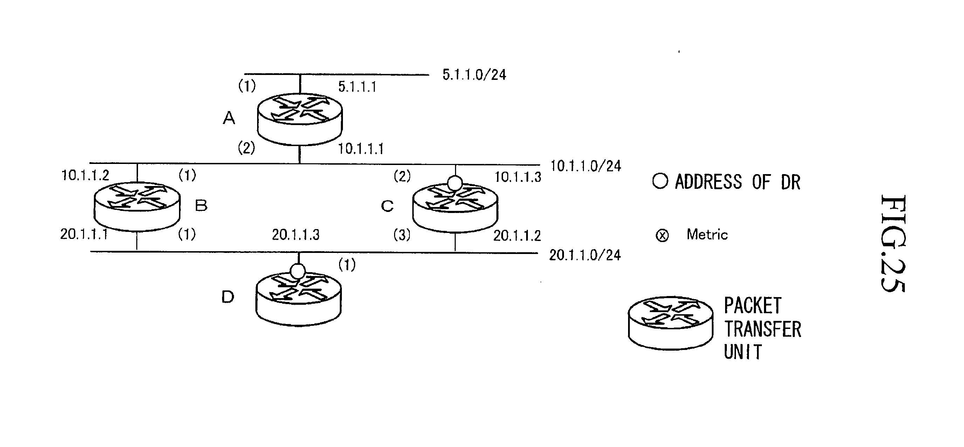

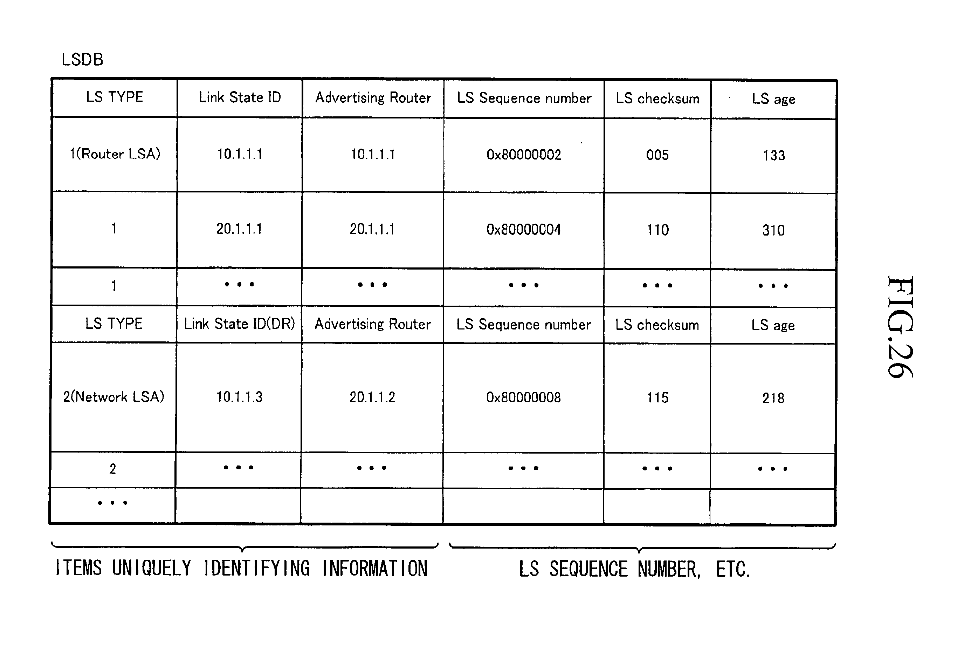

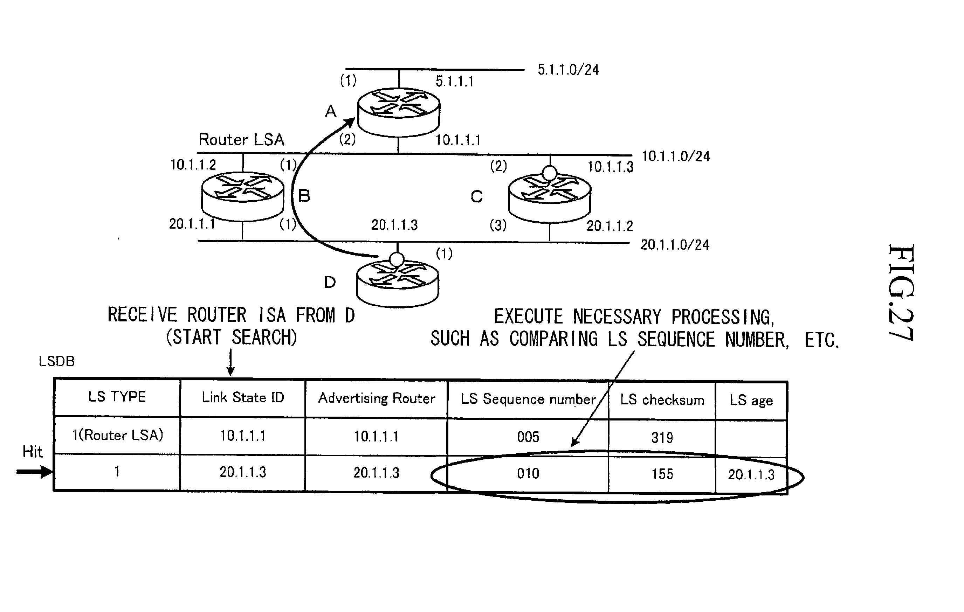

FIG. 23 illustrates the format of a Router LSA, which is a type of LSA for describing information on a packet transfer device. FIG. 24 illustrates the format of the Network LSA, which is a type of LSA for describing network information. FIG. 25 illustrates an exemplary network for illustrating examples of information to be stored in the LSDB search unit and operations of the information processing unit. FIG. 26 illustrates information stored in the LSDB search unit shown in FIG. 25. Since an LSA is uniquely identified by an LS type, a link state ID, and an advertising router, the LS type, the link state ID, and the advertising router are stored in the LSDB search unit as items that uniquely identify the information. In addition, an LS sequence number, an LS checksum, and an LS age are required in order to determine whether or not an LSA is new, these are also stored in LSDB search unit as a LS sequence number. FIG. 27 illustrates operations of the LSDB search unit upon receiving an LSA. When an LSA is received, a determination is made to determine whether or not an LSA is new using the LS type, the link state ID, and the advertising router of the received LSA as a search key.

The determination of whether or not an LSA is new is made in the following steps (1) to (6).
(1) The LSA that has the largest LS sequence number is the newest
(2) If LSAs have the same sequence number, the LSA that has the largest LS checksum is the newest
(3) If the checksums of the LSAs are identical, the LSA whose LS age reaches the MAX Age is the newest
(4) If no LS age of the LSAs reaches Max Age and the difference of the LS ages is the MAX Age Diff (15 minutes) or longer, the LSA that has the smallest LS age is the newest
(5) If any of Items (1) to (4) is not applicable, the LSAs are identical
(6) All LSAs other than the newest LSA (including a duplicating LSA) are discarded, and the newest LSA is sent to the RS. This is the step to determine whether or not an LSA is new as specified by the OSPF.

Hereinafter, exemplary configurations to provide the LSDB search unit of this example in a packet transfer device will be explained.

### (First Exemplary Configuration)

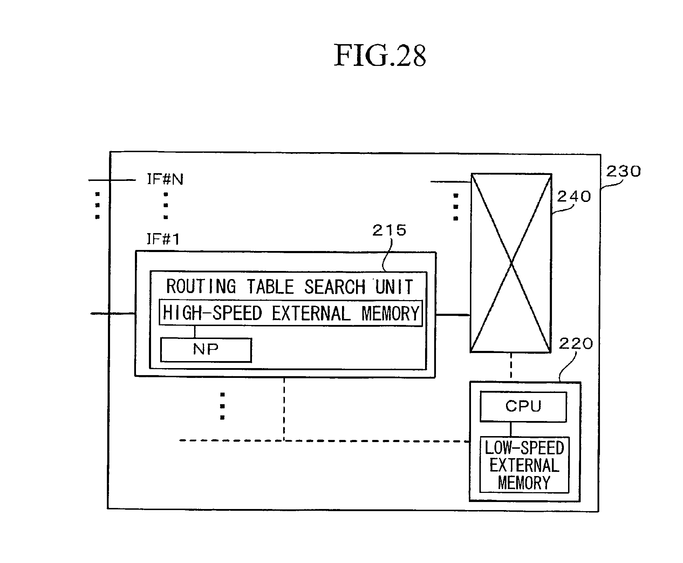

FIG. 28 shows a first exemplary configuration of a conventional packet transfer device. The packet transfer device generally includes a route server (RS) 220, a switch (SW) 240, an interface (IF: channel). The RS 220 processes a routing protocol, such as the OSPF, the ISIS, or the like, to generate a routing table, and the RS 220 transfers the generated routing table to the routing table search unit 215 of the IF. When a packet is input via an input channel, a network processor (NP) extracts destination address information, and a routing table search unit 215 determines the next hop (next router) according to the shortest path to the destination to determine an IF to which the packet is to be sent.

The first exemplary configuration of a conventional packet transfer device shown in FIG. 28 employs a search tree for the routing table search unit 215. Since only the routing table is stored in the routing table search unit 215, the memory capacity required for the routing table search unit 215 is far smaller than the memory capacity required by the RS 220. Accordingly, a high-speed external memory can be used, and the search tree can be searched faster, compared to the speed of search on a tree stored in a low-speed external memory.

### (Second Exemplary Configuration)

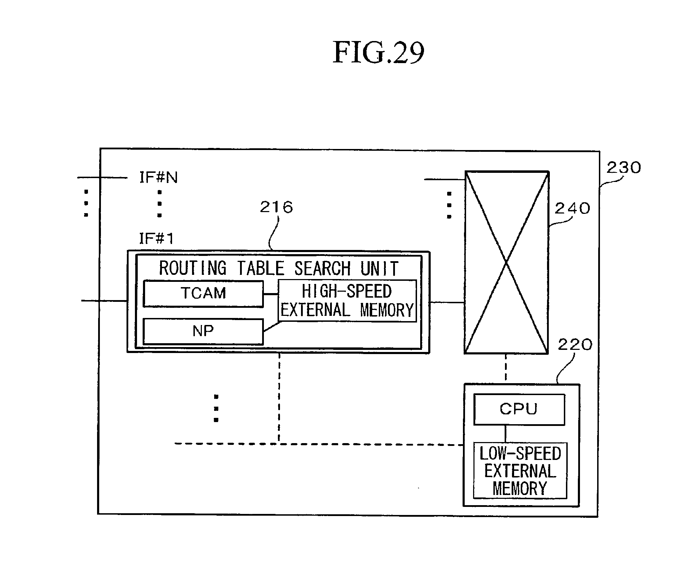

FIG. 29 illustrates a second exemplary configuration of a conventional packet transfer device. This is different from the first exemplary configuration in that the routing table search unit 216 employs a TCAM. It is required that packets be transferred as immediately as possible in a large-capacity core router, TCAMs that enable faster search than a search tree that is generally used for searching routing tables.

FIG. 19 illustrates a first exemplary configuration of a packet transfer device including the LSDB search unit 210 of the first exemplary configuration. In this configuration, the LSDB search unit 210 is provided in the IF that is separate from the routing table search unit 215. Since the LSDB search unit 210 is provided separate from the routing table search unit 215, this example is advantageous in that the routing table search unit 215 is not affected by the LSDB search unit 210 (in terms of the speed, implementation, or the like).

FIG. 21 illustrates a second exemplary configuration of a packet transfer device including the LSDB search unit 211 of the second exemplary configuration. In this example, LSDBs are searched using the routing table search unit 216 in the conventional packet transfer device 230 shown in FIG. 29.

The LSDB search units 210 and 211 shown in FIGS. 19 and 20 have the same physical configuration as the routing table search units 215 and 216 shown in FIGS. 28 and 29 (the NP is a processor and is required to function as the information processing unit), and are required to have the similar function for executing a search. Accordingly, in the second exemplary configuration, the routing table search unit 216 of the conventional packet transfer device 230 is employed for an LSDB search. This example is advantageous in terms of implementation cost because the routing table search unit 216 of the conventional packet transfer device 230 is employed.

As described above, the second embodiment of the present invention enables formation of a large network that is built using packet transfer devices, such as IP routers, with a single control domain by reducing the processing load of RSs in the packet transfer devices.

### INDUSTRIAL APPLICABILITY

The present invention enables formation of a large network that is built using packet transfer devices, such as IP routers, with a single control domain by reducing the processing load of RSs in the packet transfer devices. By this, a large IP network can be configured, and convenience for network administrators and network users can be enhanced.

## Claims

1. A routing table generating unit that generates a routing table describing a next hop to which a packet is to be sent according to a destination address of the packet that is input via an input channel, comprising
- a ternary content addressable memory, TCAM (101);
- a unit (103) that classifies items in information that is received; and
- a unit that stores an item that uniquely identifies the information among the classified items in the TCAM
a second memory (102) separated from said ternary content addressable memory TCAM and dedicated to store at least a portion of item in the received information,
the routing table generating unit **characterized by**:
a unit adapted to search the information stored in the TCAM using, as a search key, the item that uniquely identifies the information among the classified items, upon receiving new information, prior to storing the new information,
a unit adapted to initiate the storing process by the storing unit when the item that uniquely identifies the newly received information and the item that uniquely identifies the information that has been stored in the TCAM do not match in the search; and
a unit adapted to determine whether the newly received information is older than corresponding information stored in the second memory that corresponds to the item that uniquely identifies the newly received information when the item that uniquely identifies the newly received information and the item that uniquely identifies the information that has been stored in the TCAM match in the search.

2. The routing table generating unit according to claim 1, wherein said second memory is a high speed memory.

3. The routing table generating unit according to claim 2, further comprising:
a unit that ignores the newly received information, when it is determined by the comparing unit that the newly received information is as old as or older than the corresponding information stored in the high speed memory; and
a unit that, when it is determined by the comparing unit that the newly received information is newer than the corresponding information stored in the high speed memory, updates the corresponding information stored in the high speed memory with the newly received information.

4. The routing table generating unit according to claim 3, further comprising a unit that, upon an arrival of an arrived packet, searches for a shortest path using the information stored in the TCAM and the information stored in the high speed memory based on a destination address of the arrived packet.

5. The routing table generating unit according to claim 4, further comprising a unit that determines a next hop to which the arrived packet is to be sent based on the search of the shortest path.

6. A program used in a routing table generating unit that generates a routing table describing a next hop to which a packet is to be sent according to a destination address of the packet that is input via an input channel, the program, when installed in a computing device, providing the computing device with:
a function that classifies items in information that is received; and
a function that stores an item that uniquely identifies the information among the classified items in a TCAM and stores the rest of the items in an second memory separated from said ternary content addressable memory TCAM and dedicated to store at least a portion of item in the received information, said program **characterized by** :
a function that, upon receiving new information, prior to storing the new information, searches the information stored in the TCAM using, as a search key, the item that uniquely identifies the information among the classified items;
a function that initiates the storing process by the storing function when the item that uniquely identifies the newly received information and the item that uniquely identifies the information that has been stored in the TCAM do not match in the search; and
a function that, when the item that uniquely identifies the newly received information and the item that uniquely identifies the information that has been stored in the TCAM match in the search, determines whether the newly received information is older than corresponding information stored in the second memory that corresponds to the item that uniquely identifies the newly received information.

7. The program according to claim 6, further providing:
a function that ignores that newly received information, when it is determined by the comparing function that the newly received information is as old as or older than the corresponding information stored in the second memory; and
a function that, when it is determined by the comparing function that the newly received information is newer than the corresponding information stored in the second memory, updates the corresponding information stored in the second memory with the newly received information.

8. The program according to claim 7, further providing a function that, upon an arrival of an arrived packet, searches for a shortest path using the information stored in the TCAM and the information stored in the second memory based on a destination address of the arrived packet.

9. The program according to claim 8, further providing a function that determines a next hop to which the arrived packet is to be sent based on the search of the shortest path.

10. A recording medium readable from the computing device, which records the program according to claim 6.

## Patentansprüche

1. Routingtabellenerzeugungseinheit, welche eine Routingtabelle erzeugt, die einen nächsten Hop beschreibt, zu welchem ein Paket gemäß einer Zieladresse des Pakets, welches über einen Eingabekanal eingegeben ist, zu senden ist, umfassend
- einen ternären inhaltsadressierbaren Speicher, TCAM, (101);
- eine Einheit (103), weiche Elemente in Information klassifiziert, die empfangen ist; und
- eine Einheit, welche ein Element, das die Information eindeutig identifiziert, von den klassifizierten Elementen in dem TCAM speichert,
einen zweiten Speicher (102), welcher von dem ternären inhaltsadressierbaren Speicher TCAM getrennt ist und welcher dazu bestimmt ist, wenigstens einen Teil von Elementen in der empfangenen Information zu speichern,
wobei die Routingtabellenerzeugungseinheit **gekennzeichnet ist durch**:
eine Einheit, welche dazu ausgelegt ist, die in dem TCAM gespeicherte Information mittels des Elements, welches die Information eindeutig identifiziert, von den klassifizierten Elementen als ein Suchschlüssel beim Empfangen von neuer Information vor dem Speichern der neuen Information zu suchen,
eine Einheit, welche dazu ausgelegt ist, den Speichervorgang **durch** die Speichereinheit zu initiieren, wenn das Element, weiches die neu empfangene Information eindeutig identifiziert, und das Element, welches die Information eindeutig identifiziert, die in dem TCAM gespeichert wurde, bei der Suche nicht übereinstimmen; und
eine Einheit, welche dazu ausgelegt ist, zu bestimmen, ob die neu empfangene Information älter als die entsprechende, in dem zweiten Speicher gespeicherte Information ist, die dem Element entspricht, welches die neu empfangene Information eindeutig identifiziert, wenn das Element, welches die neu empfangene Information eindeutig identifiziert, und das Element, welches die Information eindeutig identifiziert, die in dem TCAM gespeichert wurde, bei der Suche übereinstimmen.

2. Routingtabellenerzeugungseinheit nach Anspruch 1, wobei der zweite Speicher ein Hochgeschwindigkeitsspeicher ist.

3. Routingtabellenerzeugungseinheit nach Anspruch 2, ferner umfassend:
eine Einheit, weiche die neu empfangene Information ignoriert, wenn es durch die Vergleichseinheit bestimmt ist, dass die neu empfangene Information so alt wie oder älter als die entsprechende Information ist, welche in dem Hochgeschwindigkeitsspeicher gespeichert ist; und
eine Einheit, welche, wenn es durch die Vergleichseinheit bestimmt ist, dass die neu empfangene Information neuer als die entsprechende Information ist, die in dem Hochgeschwindigkeitsspeicher gespeichert ist, die entsprechende Information, die in dem Hochgeschwindigkeitsspeicher gespeichert ist, mit der neu empfangenen Information aktualisiert.

4. Routingtabellenerzeugungseinheit nach Anspruch 3, ferner umfassend eine Einheit, welche bei Ankunft eines angekommenen Pakets nach einem kürzesten Pfad mittels der Information, welche in dem TCAM gespeichert ist, und der Information, welche in dem Hochgeschwindigkeitsspeicher gespeichert ist, basierend auf einer Zieladresse des angekommenen Pakets sucht.

5. Routingtabellenerzeugungseinheit nach Anspruch 4, ferner umfassend eine Einheit, welche einen nächsten Hop, zu welchem das angekommene Paket zu senden ist, basierend auf der Suche nach dem kürzesten Pfad bestimmt.

6. Programm, welches in einer Routingtabellenerzeugungseinheit verwendet wird, die eine Routingtabelle erzeugt, welche einen nächsten Hop beschreibt, zu weichem ein Paket gemäß einer Zieladresse des Pakets zu senden ist, welches über einen Eingabekanal eingegeben ist, wobei das Programm, wenn es auf einem Computergerät installiert ist, das Computergerät versieht mit:
einer Funktion, welche Elemente in Information klassifiziert, die empfangen ist; und
einer Funktion, welche ein Element, das die Information eindeutig identifiziert, von den klassifizierten Elementen in einem TCAM und den Rest der Elemente in einem zweiten Speicher speichert, welcher von dem ternären inhaltsadressierbaren Speicher TCAM getrennt ist und welcher dazu bestimmt ist, wenigstens einen Teil von Elementen in der empfangenen Information zu speichern, wobei das Programm **gekennzeichnet ist durch**:
eine Funktion, welche beim Empfangen von neuer Information vor dem Speichern der neuen Information die Information, welche in dem TCAM gespeichert ist, mittels des Elements, welches die Information eindeutig identifiziert, von den klassifizierten Elementen als einen Suchschlüssel sucht;
eine Funktion, welche den Speichervorgang **durch** die Speicherfunktion initiiert, wenn das Element, welches die neu empfangene Information eindeutig identifiziert, und das Element, welches die Information eindeutig identifiziert, die in dem TCAM gespeichert wurde, bei der Suche nicht übereinstimmen; und
eine Funktion, welche, wenn das Element, welches die neu empfangene Information eindeutig identifiziert, und das Element, welches die Information eindeutig identifiziert, die in dem TCAM gespeichert wurde, bei der Suche übereinstimmen, bestimmt, ob die neu empfangene Information älter als entsprechende Information ist, welche in dem zweiten Speicher gespeichert ist, die dem Element entspricht, welches die neu empfangene Information eindeutig identifiziert.

7. Programm nach Anspruch 6, ferner bereitstellend:
eine Funktion, welche die neu empfangene Information ignoriert, wenn es durch die Vergleichsfunktion bestimmt ist, dass die neu empfangene Information so alt wie oder älter als die entsprechende Information ist, die in dem zweiten Speicher gespeichert ist; und
eine Funktion, welche, wenn es durch die Vergleichsfunktion bestimmt ist, dass die neu empfangene Information neuer als die entsprechende Information, die in dem zweiten Speicher gespeichert ist, die entsprechende Information, die in dem zweiten Speicher gespeichert ist, mit der neu empfangenen Information aktualisiert.

8. Programm nach Anspruch 7, ferner bereitstellend eine Funktion, welche bei Ankunft eines angekommenen Pakets nach einem kürzesten Pfad mittels der Information, die in dem TCAM gespeichert ist, und der Information, die in dem zweiten Speicher gespeichert ist, basierend auf einer Zieladresse des angekommenen Pakets sucht.

9. Programm nach Anspruch 8, ferner bereitstellend eine Funktion, welche einen nächsten Hop, zu welchem das angekommene Paket zu senden ist, basierend auf der Suche nach dem kürzesten Pfad bestimmt.

10. Aufzeichnungsmedium, welches von dem Computergerät lesbar ist, welches das Programm nach Anspruch 6 aufzeichnet.

## Revendications

1. Unité de génération de table de routage qui génère une table de routage décrivant un prochain bond auquel un paquet doit être envoyé selon une adresse de destination de paquet qui est entrée via un canal d'entrée, comprenant
- une mémoire adressable par contenu ternaire, TCAM (101) ;
- une unité (103) qui classe des articles dans une information qui est reçue ; et
- une unité qui stocke un article qui identifie de façon unique l'information parmi les articles classés dans la TCAM ;
une seconde mémoire (102) séparée de ladite mémoire adressable par contenu ternaire TCAM et dédiée au stockage d'au moins une portion de l'article dans l'information reçue,
l'unité de génération de table de routage étant **caractérisée par** :
une unité adaptée pour rechercher l'information stockée dans la TCAM en utilisant, comme clé de recherche, l'article qui identifie de façon unique l'information parmi les articles classés, lors de la réception d'une nouvelle information, avant de stocker la nouvelle information,
une unité adaptée pour déclencher le processus de stockage par unité de stockage lorsque l'article qui notifie de façon unique l'information nouvellement reçue et l'article qui identifie de façon unique l'information qui a été stockée dans la TCAM ne correspondent pas dans la recherche ; et
une unité adaptée pour déterminer si l'information nouvellement reçue est plus ancienne que l'information correspondante stockée dans la seconde mémoire qui correspond à l'article qui identifie de façon unique l'information nouvellement reçue, lorsque l'article qui identifie de façon unique information nouvellement reçue et l'article qui identifie de façon unique l'information qui a été stockée dans la TCAM correspondent dans la recherche.

2. Unité de génération de table de routage selon la revendication 1, dans laquelle ladite seconde mémoire est une mémoire rapide.

3. Unité de génération de table de routage selon à revendication 2, comprenant en outre :
une unité qui ignore l'information nouvellement reçue, lorsqu'il est déterminé par l'unité de capacité que l'information nouvellement reçue est aussi ancienne ou plus ancienne que l'information correspondante stockée dans la mémoire rapide ; et
une unité qui, lorsqu'il est déterminé par l'unité de comparaison que l'information nouvellement reçue est plus récente que l'information correspondante stockée dans la mémoire rapide, met à jour l'information correspondante stockée dans la mémoire rapide avec information nouvellement reçue.

4. Unité de génération de table de routage selon la revendication 3, comprenant en outre une unité qui, lors d'une arrivée d'un paquet arrivé, recherche un chemin le plus court en utilisant l'information stockée dans la TCAM et l'information stockée dans la mémoire rapide en se basant sur une adresse de destination du paquet arrivé.

5. Unité de génération de table de routage selon la revendication 4, comprenant en outre une unité qui détermine un prochain bond auquel le paquet arrivé doit être envoyé en se basant sur la recherche du chemin le plus court.

6. Programme utilisé dans une unité de génération de table de routage qui génère une table de routage décrivant un prochain bond auquel un paquet doit être envoyé selon une adresse de destination de paquet qui est entrée via un canal d'entrée, le programme, lorsqu'il est installé dans un dispositif informatique, fournissant au dispositif informatique :
une fonction qui classe des articles dans une information qui est reçue ; et
une fonction qui stocke un article qui identifie de façon unique l'information parmi les articles classés dans une TCAM et stocke le reste des articles dans une seconde mémoire séparée de ladite mémoire adressable par contenu ternaire TCAM et dédiée au stockage d'au moins une portion d'un article dans l'information reçue, ledit programme étant **caractérisé par** :
une fonction qui, lors de la réception d'une nouvelle information, avant de stocker la nouvelle information, recherche l'information stockée dans la TCAM en utilisant, comme clé de recherche, l'article qui identifie de façon unique l'information parmi les articles classés ;
une fonction qui déclenche le processus de stockage par la fonction de stockage lorsque l'article qui identifie de façon unique l'information nouvellement reçue et l'article qui identifie de façon unique l'information qui a été stockée dans la TCAM ne correspondent pas dans la recherche ; et
une fonction qui, lorsque l'article qui identifie de façon unique l'information nouvellement reçue et l'article qui identifie de façon unique l'information qui a été stockée dans la TCAM correspondent dans la recherche, détermine si l'information nouvellement reçue est plus ancienne qu'une information correspondante stockée dans la seconde mémoire qui correspond à l'article qui identifie de façon unique l'information nouvellement reçue.

7. Programme selon la revendication 6, fournissant en outre :
une fonction qui ignore cette information nouvellement reçue, lorsqu'il est déterminé par la fonction de comparaison que l'information nouvellement reçue est aussi ancienne ou plus ancienne que l'information correspondante stockée dans la seconde mémoire ; et
une fonction qui, lorsqu'il est déterminé par la fonction de comparaison que l'information nouvellement reçue est plus récente que l'information correspondante stockée dans la seconde mémoire, met à jour l'information correspondante stockée dans la seconde mémoire avec l'information nouvellement reçue.

8. Programme selon la revendication 7, fournissant en outre une fonction qui, lors de l'arrivée d'un paquet arrivé, recherche un chemin le plus court en utilisant l'information stockée dans la TCAM et l'information stockée dans la seconde mémoire en se basant sur une adresse de destination du paquet arrivé.

9. Programme selon la revendication 8, fournissant en outre une fonction qui détermine un prochain bond auquel le paquet arrivé doit être envoyé en se basant sur la recherche du chemin le plus court.

10. Support d'enregistrement loisible par le dispositif informatique, qui enregistre le programme selon la revendication 6.
